## Europäisches Patentamt
## European Patent Office
## Office européen des brevets

(11) Publication number: **0 178 004**
**B1**

# EUROPEAN PATENT SPECIFICATION

(45) Date of publication of patent specification: **31.05.89**

(51) Int. Cl.⁴: $H\ 01\ L\ 21/205$, $H\ 01\ L\ 29/08$

(21) Application number: **85201504.9**

(22) Date of filing: **19.09.85**

(54) A bipolar hetero-junction transistor and method of producing the same.

(30) Priority: **02.10.84 NL 8403005**
**19.06.85 NL 8501769**

(43) Date of publication of application:
**16.04.86 Bulletin 86/16**

(45) Publication of the grant of the patent:
**31.05.89 Bulletin 89/22**

(84) Designated Contracting States:
**AT BE CH DE FR GB IT LI LU NL SE**

(56) References cited:
FR-A-2 309 981
FR-A-2 352 404
US-A-4 357 179
US-A-4 451 538
EXTENDED ABSTRACTS, vol. 80, no. 2, 1980, pages 1423-1425, Pennington, US; T. ICHIMURA et al.: "a-Si: H films by D.C. glow discharge"
APPLIED PHYSICS LETTERS, vol. 43, no. 11, December 1983, pages 1045-1047, New York, US; G. RAJESWARAN et al.: "Substrate temperature dependence of microcrystallinity in plasmadeposited, boron-doped hydrogenated silicon alloys"
The file contains technical information submitted after the application was filed and not included in this specification

(73) Proprietor: IMEC Inter Universitair Micro-Electronica Centrum
Kapeldreef 75
B-3030 Leuven-Heverlee (BE)

(72) Inventor: Ghannam, Moustafa Yehia
Ijzerenmolenstraat 154/74
B-3030 Leuven-Heverlee (BE)
Inventor: Mertens, Robert
Koetsiersweg 50
B-3203 Linden (BE)
Inventor: Nijs, Johan
Heidebergstraat 124
B-3200 Kessel-lo (BE)

(74) Representative: Cammel, Willem Frans et al
OCTROOIBUREAU ARNOLD & SIEDSMA
Sweelinckplein 1
NL-2517 GK The Hague (NL)

**Description**

This invention relates to a bipolar hetero-junction transistor comprising layers forming emitter, base and collector, the hetero-junction being the emitter-base junction.

Such a bipolar hetero-junction transistor having a high current gain ($\beta$-factor) is known from FR—A—23 52 404 in which a heterojunction is formed between AlGaAs and GaAs using III-V techniques with AlGaAs having a bandgap of 2.3 eV. This epitaxial technique can only be controlled with difficulty and is very expensive.

Further there is known a bipolar transistor where the emitter-base junction consists of polycrystalline and monocrystalline silicon. In this technique doping impurities-diffuse at high temperatures from the polycrystalline layer — forming part of the emitter into the monocrystalline base, causing an undefined junction between emitter and base. The explanation for the $\beta$-increase is uncertain or it is explained in terms of a lower diffusion coefficient of minority carriers in the polycrystalline part of the emitter, or in terms of the presence of a thin oxide between the polycrytalline and monocrystalline layer or a combination of both.

Another technique in the silicon technology for producing bipolar hetero-junction transistors is the SIPOS technique (for example see FR—A—2309981) in which the layer forming the emitter is made from an $O_2$—$SiH_4$—$N_2O$—$PH_3$ vapour at about 650°C so that phosphorus-doped $Si$—$SiO_2$-polycristalline structure is obtained. Subsequently, in order to reduce the state density at the junction surface said material is annealed at a temperature of 900°C in a $H_2$ ambient, after which the emitter layer exhibits an energy gap of 1.5 eV. A disadvantage of this technique is that due to annealing at a high temperature phosphorus diffuses into the base layer and disturbs the accurately defined emitter-base junction so that the transition between the energy gap in the emitter layer and the energy gap in the base layer becomes less sharply defined. Further such a transistor has a high resistance value of the emitter because of the isolating $SiO_2$.

The main object of this invention is to provide a bipolar hetero-junction silicon transistor with a high band-gap in the emitter which means high gain without charge build up at the hetero-junction, that is also simple to produce and so inexpensive.

Therefore in the transistor produced by the method of Claim 1, the layer forming the emitter consists of doped and hydrogenated silicon material at least partly in amorphous form.

A high current gain is obtained here because the barrier for injection of minority carriers to the emitter is increased due to the layer bandgap of the emitter material. Also because of this layer bandgap the intrinsic carrier concentration $M_i$ in the emitter is decreased.

This transistor is very suitable for high frequency applications and can be used in any sort of semiconductor technology such as differential amplifiers, operational amplifiers as well as all sorts of fast digital IC's with a high gain $\beta$.

Partly in amorphous form covers the region from completely amorphous hydrogenated silicon ($a$-Si:H), over microcrystalline silicon ($\mu c$-Si) consisting of small crystallites with typical average dimensions between 2 and 100 nm, embedded in an amorphous matrix, till a continuous structure of grains and grain boundaries, with typical average dimensions of the grains between 2 and 100 nm. In any case the hydrogen content in the material is essential, and also the bandgap being larger or equal (in the extreme case of poly-Si with grains larger than 100 nm) to that of crystalline Si ($c$-Si). The higher the production or annealing temperature of the silicon the higher the number and/or size of the crystallites giving at the end polycrystalline silicon, generally recognized as a continuous structure of grains with grain boundaries, with typical dimensions of at least 100 nm. The resistivity value of the layer forming the emitter is approximately 1—1000 $\Omega$cm in the case of completely amorphous and down to $10^{-3}$ $\Omega$cm in the case of $\mu c$-Si.

Amorphous silicon that is doped and hydrogenated silicon is known for the production of solar cells, see for instance US—A—4457538, which have other requirements than transistors.

In a preferred embodiment of the invention the layer forming the emitter is made of microcrystalline silicon ($\mu c$-Si) having crystallites with typical dimensions of 2—100 nm and formed within an amorphous matrix. The higher the production temperature of the silicon the higher the density of crystallites will be and in the end the so-called polycrystalline state will be reached with no amorphous silicon left, although generally polycrystalline semiconductor material has much larger crystallites. This microcrystalline emitter has a low resistance value and so the transistor is very useful as a power transistor at high currents and at high frequencies.

For the production of solar cells only, microcrystalline silicon is known for example from US—A—4357179 and from articles in Extended Abstracts vol. 00—21 1980 of T. Ichimura e.a. "$a$-Si: H-films by DC glow discharge" and in Applied Physics letters vol. 43 no. 11 December 1983 (NY, US) by G. Rajeswaran e.a. "Substrate temperature dependence of microcrystallining in plasma-deposited boron-doped hydrogenated silicon alloys", but those applications have further nothing to do with the transistor according to this invention.

The resistivity value of the layer forming the emitter is approximately 1—10 $\Omega$cm or even $10^{-3}$ $\Omega$cm in case of $\mu c$-Si.

In a preferred embodiment of the transistor according to the invention the layer forming the emitter has a thickness of less than 0.5 $\mu$m, which is made possible by the sharply defined heterojunction between amorphous and monocrystalline silicon. Because of this thin base layer the base resistance value is small, which is essential for transistors at high frequencies.

Further the invention provides methods to produce the transistor according to the invention.

In the known classical technology in manufacturing a layer forming the emitter of a homo-junction transistor phosphorus is caused to diffuse into a chip of monocrystalline silicon (c-Si) at about 900°C or is doped by means of ion-implantation. In order to obtain a high collector current IC the emitter-forming layer has to be doped to a high donor density $N_d$, for example, to $3.10^{20}$ atoms/cm$^3$. The value of the base current is determined by the energy gap in the emitter-forming layer in monocrystalline silicon of about 1.1 eV.

A disadvantage of this known method is, that de to the strong doping the energy gap in the emitter-forming layer decreases to about 0.9 eV so that the base current increases and the factor $\beta$ is adversely affected. Due to the small energy gap a relatively high minority current flows into the emitter. It is, moreover, disadvantageous in this known method to choose the base forming layer to be thinner than 0.5 μm because of the high value of the base resistance and the low value of the breakdown voltage across the base.

According to the invention the layer forming the emitter is applied on the layer forming the base at a temperature up to 450°C, by means of a plasma comprising ions, radicals and neutral parts of semiconductor material and hydrogen, such that the layer forming the emitter substantially consists of doped and hydrogenated semiconductor material at least partly in amorphous form.

Since a plasma is used, the temperature of the substrate can be kept low (≤450°C), because it is the power between the two electrodes that creates the film depositing particles from the gas phase and hence determines the growth rate, while independently the substrate temperature determines the hydrogen content as explained above. It will be understood that the amorphous layer can also be deposited by other techniques known per se, such as special LP CVD (low pressure chemical vapour deposition) techniques (HOMO CVD, PHOTO CVD, LASER CVD) and such as sputtering, but always so that the substrate temperature does not determine the growth rate, can be kept low and only determines the hydrogen content in the film, which produces a high bandgap in the emitter.

Preferably hydrogen ($H_2$) is added to the plasma with a relatively high partial pressure such that the layer forming the emitter substantially consists of doped and hydrogenated semiconductor material in microcrystalline form.

By adding $H_2$ to the plasma the deposition rate can be controlled, while the temperature of the substrate $T_s$ controls the hydrogen content in the layer, so that the microcrystals can form itself with a size depending on the balance between growth rate and deposition rate.

Further features and characteristics of the invention will be described with reference to a drawing.

The drawing shows in

Fig. 1 a schematic representation of a bipolar hetero-junction — npn transistor embodying the invention;

Fig. 2 a schematic sectional view of a device for carrying out the method in accordance with the invention;

Fig. 3 a schematic representation of the transition of the energy gap in the emitter-base junction of the transistor of Fig. 1;

Fig. 4 a graph of the behaviour for low current values of an npn transistor embodying the invention;

Fig. 5 a graph of the behaviour for high current values of an npn transistor embodying the invention;

Fig. 6 a graph of the current amplification factor $\beta$ of a transistor of Fig. 1 plotted against the base Gummel number GG;

Fig. 7 a strongly enlarged top view of a bipolar hetero-junction transistor of Fig. 1; and

Fig. 8 a section over line VIII—VIII of Fig. 7; and

Fig. 9 a graph showing the transition from amorphous to μc-Si.

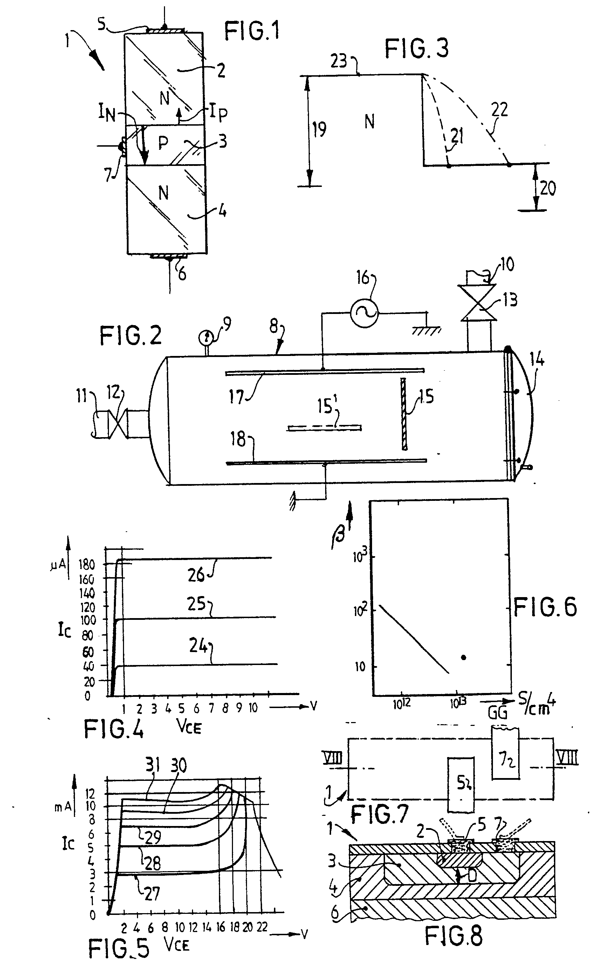

A npn transistor 1 embodying the invention (Fig. 1, 7, 8) is formed by an emitter layer 2 provided with an emitter contact 5 consisting of phosphorus-doped and hydrogenated silicon in an amorphous or microcrystalline form, by an acceptor-doped base layer 3 provided with a base contact 7 and consisting of monocrystalline silicon and by a donor-doped collector layer 4 of monocrystalline silicon provided with a collector contact 6. The thickness D (Fig. 8) can for instance be only a few tenth of a micrometer. The current amplification factor $\beta$ is defined as follows:

$$\beta = \frac{I_C}{I_B} = \frac{I_N}{I_P}$$

wherein $I_N$ is the absolute value of the electron current from emitter to collector, $I_P$ is the value of the hole current from base to emitter, $I_C$ is the value of the collector current. The second = sign only applies when the base recombination value is negligible and the recombination at the junction between amorphous (or microcrystalline) and monocrystalline material is negligible.

The emitter layer of the transistor embodying the invention is arranged in a chamber 8 held at a temperature of about 250°C and provided with a pressure gauge 9, with inlet and outlet channels 10, 11 including cocks 12, 13 and with removable cover 14 so that at least one silicon chip 15 provided with the collector layer and the base layer and as precursor silane ($SiH_4$) or $AsH_3$ and phosphine ($PH_3$ about 1% of the amount of $SiH_4$) can be disposed in the chamber 12. By means of an alternating voltage source with a preset power value or, as the case may be, a direct voltage source 16 a plasma is generated between the electrodes 17, 18 so that the emitter layer is applied to the base layer at a pressure of 1 to 1000 mTorr (1 Torr = 133 Pa) and at a temperature of 250°C. The substrate temperature is determining the amount of hydrogen that remains in the amorphous silicon emitter layer, e.g. for 250°C the amount of hydrogen that remains in the film is typically 5—10%. Because of the contents of the gas mixture the sintering at high temperature essential for, for instance the SIPOS-techniques can be dispensed with. The electrode 18 is grounded. The electrode 17 is connected to the voltage source, which is also grounded. Since a plasma is used, the temperature can be kept low. The silicon chip is disposed either vertically (indicated by the solid line 15) or horizontally (indicated by the broken line 15'). The layers forming the base and the collector are applied by means of methods known per se. In order to obtain satisfactory contacts Ti (0.5 μm)-Al(1 μm) was vapour-deposited on the amorphous silicon layer and on the layer forming the base. For improving further the contacts tempering is carried out at 290°C for 25 minutes. Tempering at a high temperature as in the SIPOS-technique can be dispensed with, since at the formation from the plasma the emitter layer is already hydrogenated.

To produce an emitter layer in microcrystalline form, i.e. an amorphous matrix with very small crystalline areas therein, the method was used at a pressure of about 50 mTorr in the chamber 8, the voltage source supplying to the plasma a smaller power value than at producing the amorphous emitter layer. The exact pressure value and the exact power value must be determined depending on the dimensions of the chamber.

The transition between an energy gap 19 in the phosphorus-doped N layer and an energy gap 20 in the slightly doped P layer is illustrated in Fig. 3 which also shows the doping profile. The energy gap 19 is, for example, 1.6 eV and the energy gap 20 is, for example, 1.1 eV. The solid line indicates the doping profile at the npn junction (emitter base) of the transistor embodying the invention. The broken lines 21, 22 represent the doping profile in accordance with the known techniques such as the diffusion technique and the SIPOS-technique for applying the emitter layer, in which case due to the high temperature donor material (phosphorus) can diffuse as far as into the base layer. The broken line 21 indicates by way of example a doping profile in a SIPOS-transistor sintered for a short time. The broken line 21 indicates by way of example a doping profile in a transistor in accordance with the diffusion technique. Owing to the accurately defined emitter-base junction in the transistor embodying the invention the thickness of the base layer can be chosen smaller than in the transistors hitherto used, for example, smaller than 0.5 μm, which brings about an increase in collector current $I_c$ and hence a higher β. At a given value of β a lower value of the base resistance is thus obtained.

The lines 24, 25, 26, 27, 28, 29, 30, 31 indicate the collector current $I_c$ (in μA (Fig. 4) in mA (Fig. 5) of the transistor embodying the invention using α-Si:H at a constant case current $I_B$ of 10 μA, 20 μA, 30 μA, 200 μA, 400 μA, 600 μA, 800 μA and 1 mA respectively in relation to the collector-emitter voltage $V_{ce}$ in Volt plotted on the abcissae.

In Fig. 6 the current amplification factor β is plotted vertically against the base Gummel number. The base Gummel number is defined as being the quotient of the density per surface and the diffusion coefficient of minority charge carriers in the base layer. The electron current $I_N$ and hence the β factor are inversely proportional to the base Gummel number. The solid line (Fig. 6) illustrates the relationship for bipolar homo-junction transistors. Fig. 6 shows a measuring point on the transistor embodying the invention, using α-Si:H. Since the hetero-junction transistor has a high base Gummel number and at this base Gummel number an approximately 5 to 6 times higher β factor, the hetero-junction transistor embodying the invention will exhibit also a higher current amplification factor β at lower values of the base Gummel number than the conventional bipolar homo-junction transistors.

It will be understood that a bipolar hetero-junction transistor of the invention can be produced by means of foto-dissociation of $SiH_4$, known per se, with the gas in the chamber staying below 450°C.

While cooling a substrate provided with a base layer at about 300°C, it is possible to produce a bipolar heter-junction transistor according to the invention by means of chemical vapour deposition (CVD).

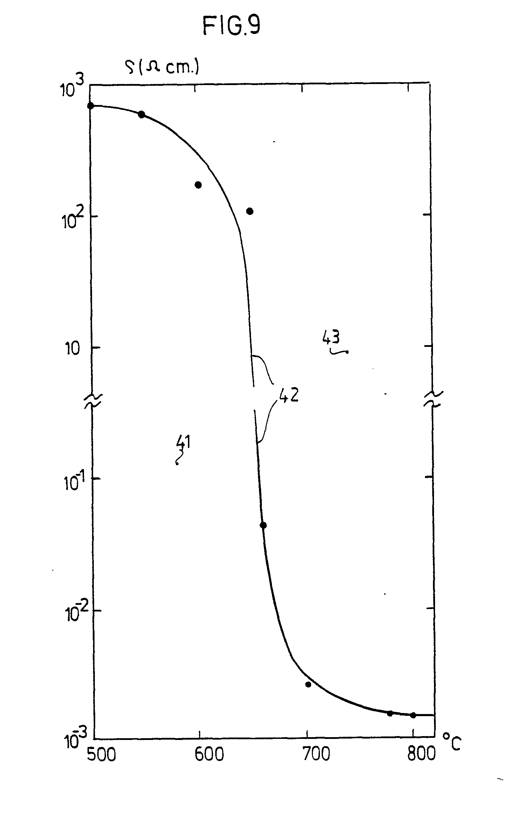

It is also possible for obtaining a transistor having a microcrystalline emitter layer to heat a transistor having an amorphous emitter layer from about 550°C to about 750°C. In Fig. 9 line 42 is showing the transistor of α-Si into μc-Si, line 42 being resistivity of the material as a function of the temperature for annealing during 20 minutes, the area 41 being amorphous silicon and the area 43 being microcrystalline silicon.

It will be understood for one skilled in the art, that the use of a bipolar hetero-junction transistor of the invention is unlimited. It can be used as a power transistor, and for high frequency purposes, also in the analog or digital IC-technique, even submicron. An engineer has one more degree of freedom for the design of a transistor suitable for high frequencies and for power applications, because of the combination of low base resistance and high current gain made possible by the present invention. Also because of the high bandgap in the emitter there is no charge built-up at the junction, which makes a transistor according to the present invention even more suitable for high frequency purposes. The applications for such transistors can be used for instance in the area of computers (mainframe, (super)mini), curve trancers, oscilloscopes, operational amplifiers (audio, video, ...) fast memories, microwave circuits, etc.

## Claims

1. A method of producing a bipolar heterojunction silicon transistor, comprising the steps of:
— providing a collector layer (4) of one conductivity type;
— forming a base layer (3) in or on the collector layer, which base layer is crystalline and doped such that it has the other conductivity type; and
— applying in or on said base layer (3) at a temperature below 450°C an emitter layer (2) consisting of doped and hydrogenated silicon material of the first conductivity type, at least partly in amorphous form, viz. ranging from completely amorphous hydrogenated silicon (α-Si:H), over microcrystalline silicon (μc-Si) consisting of small crystallites showing typical average dimensions between 2 and 100 nm, embedded in an amorphous matrix, to a continuous structure of grains and grain boundaries.

2. The method according to claim 1, in which the emitter layer (2) is applied by means of Plasma Chemical Vapour Deposition (PVCD).

3. The method of claim 2, in which hydrogen (H₂) is added to the plasma with a relatively high partial pressure, such that the emitter layer (2) substantially consists of doped and hydrogenated silicon material in microcrystalline form.

4. The method of any of claims 1 to 3, wherein the base layer is formed with a thickness of less than 0.5 μm.

5. A bipolar heterojunction silicon transistor, comprising:
— a collector layer (4) of one conductivity type,
— a base layer (3) formed in or on the collector layer, said base layer being cristalline and doped to show the other conductivity type;
— and an emitter layer (2) provided in or on said base layer, consisting of doped and hydrogenated silicon material of the first conductivity type, at least partly in amorphous form, viz. ranging from completely amorphous hydrogenated silicon (α-Si:H), over microcrystalline silicon (μc-Si) consisting of small crystallites showing typical average dimensions between 2 and 100 nm, embedded in an amorphous matrix, to a continuous structure of grains and grain boundaries.

6. A bipolar heterojunction transistor (1) according to claim 5, wherein the base layer has a thickness of less than 0.5 μm.

## Patentansprüche

1. Verfahren zum Erzeugen eines Bipolar-Siliziumtransistors mit Heteroübergang mit den Schritten:
— Vorsehen einer Kollektorschicht (4) eines Leitfähigkeits-typs;
— Bilden einer Basisschicht (3) in oder auf der Kollektorschicht, welche Basisschicht kristallin und derart dotiert ist, daß sie den anderen Leitfähigkeitstyp aufweist; und
— Auftragen einer Emitterschicht (2) in oder auf die Basisschicht (3) bei einer Temperatur unterhalb von 450°C, wobei die Emitterschicht (3) aus dotiertem und hydriertem Siliziummaterial des ersten Leitfähigkeitstyps mindestens teilweise in amorpher Form besteht, nämlich im Bereich von vollständig amorphem hydriertem Silizium (α-Si:H), über mikrokristallines Silizium (μc-Si), welches aus kleinen, typische durchschnittliche Abmessungen zwischen 2 und 100 nm zeigenden Kristalliten besteht, die in einer amorphen Matrix eingebettet sind, bis zu einer kontinuierlichen Struktur von Körnern und Korngrenzen.

2. Verfahren nach Anspruch 1, bei dem die Emitterschicht (2) mit Hilfe von Plasma-Gasphasen-Abschieden (PVCD) aufgetragen wird.

3. Verfahren nach Anspruch 2, bei dem Wasserstoff (H₂) zu dem Plasma mit einem relativ hohen Partialdruck so hinzugefügt wird, daß die Emitterschicht (2) im wesentlichen aus dotiertem und hydriertem Siliziummaterial in mikrokristalliner Form besteht.

4. Verfahren nach einem der Ansprüche 1 bis 3, bei dem die Basisschicht mit einer Dicke von weniger als 0,5 μm gebildet ist.

5. Bipolar-Siliziumtransistor mit Heteroübergang mit:
— einer Kollektorschicht (4) des einen Leitfähigkeitstyps;
— einer Basisschicht (3), die in oder auf der Kollektorschicht gebildet ist, wobei die Basisschicht kristallin und dotiert ist, so daß sie den anderen Leitfähigkeitstyp aufweist;
— und einer Emitterschicht (2), die in oder auf der Basisschicht vorgesehen ist, aus dotiertem und hydriertem Siliziummaterial des ersten Leitfähigkeitstyps besteht, zumindest teilweise in amorpher Form, nämlich in dem Bereich von vollständig amorphem hydriertem Silizium (α-Si:H), über mikrokristallines Silizium (μc-Si), das aus kleinen Kristalliten besteht, die typische durchschnittliche Abmessungen zwischen 2 und 100 nm zeigen und in einer amorphen Matrix eingebettet sind, bis zu einer kontinuierlichen Struktur von Körnern und Korngrenzen.

6. Bipolartransistor (1) mit Heteroübergang nach Anspruch 5, bei dem die Basisschicht eine Dicke von weniger als 0,5 μm aufweist.

## Revendications

1. Procédé de fabrication d'un transistor au silicium bipolaire à hétérojonction, caractérisé en ce qu'il comprend les opérations suivantes:
— on prévoit une couche de collecteur (4) d'un type de conductivité;
— on forme une couche de base (3) dans ou sur la couche de collecteur, laquelle couche de base est cristalline et dopée en sorte d'avoir l'autre type de conductivité; et
— on applique dans ou sur ladite couche de base (3) à une température inférieure à 450°C und couche d'émetteur (2) composée de silicium dopé et hydrogéné du premier type de conductivité, au moins partiellement à l'état amorphe, c'est-à-dire allant du silicium hydrogéné complètement amorphe (α-Si:H) en passant par le silicium

microscristallin (µc-Si) composé de petites cristallites présentant des dimensions moyennes types de 2 à 100 nm, noyées dans une matrice amorphe, à une structure continue de grain et de limites de grain.

2. Procédé selon la revendication 1, caractérisé en ce qu'on applique la couche d'émetteur par dépôt de vapeur chimique sous plasma (PVCD).

3. Procédé selon la revendication 2, caractérisé en ce qu'on ajoute au plasma de l'hydrogène (H₂) sous pression partielle relativement élevée, en sorte que la couche d'émetteur (2) soit sensiblement composée de silicium dopé et hydrogéné à l'état microcristallin.

4. Procédé selon l'une quelconque des revendications 1 à 3, caractérisé en qu'on donne à la couche de base une épaisseur inférieure à 0,5 µm.

5. Transistor au silicium bipolaire à hétérojonction, caractérisé en ce qu'il comprend:

— une couche de collecteur (4) d'un type de conductivité,

— une couche de base (3) formée dans ou sur la couche de collecteur, ladite couche de base étant cristalline et dopée pour présenter l'autre type de conductivité;

— et une couche d'émetteur (2) prévue dans ou sur ladite couche de base, composée de silicium dopé et hydrogéné du premier type de conductivité, au moins partiellement à l'état amorphe, c'est-à-dire allant du silicium hydrogéné complètement amorphe (α-Si:H), en passant par le silicium microcristallin (µc-Si) composé de petites cristallites présentant des dimensions moyennes types de 2 à 100 nm, noyées dans une matrice amorphe, à une structure continue de grain et de limites de grain.

6. Transistor bipolaire à hétérojonction (1) selon la revendication 5, caractérisé en ce que la couche de base a une épaisseur de moins de 0,5 µm.

FIG.1

FIG.3

FIG.2

FIG.4

FIG.6

FIG.7

FIG.5

FIG.8

## FIG.9